# EUROPEAN PATENT SPECIFICATION

(11) **EP 4 632 307 B1**
(45) Date of publication and mention of the grant of the patent: **02.09.2026**
(21) Application number: 25164042.1
(22) Date of filing: 17.03.2025
(51) Int. Cl.: F28D 1/047, F28F 1/02, H01M 10/613, H01M 10/625, H01M 10/6556, H01M 10/6568, F28F 27/02, F28D 21/00, H01M 10/643, H01M 10/6555, H01M 10/6557, F28F 9/02

(54) **SHUNT DEVICE, COOLING DEVICE, BATTERY PACK AND ELECTRICAL DEVICE**
SHUNT-VORRICHTUNG, KÜHLVORRICHTUNG, BATTERIEPACK UND ELEKTRISCHE VORRICHTUNG
DISPOSITIF DE DÉRIVATION, DISPOSITIF DE REFROIDISSEMENT, BLOC-BATTERIE ET DISPOSITIF ÉLECTRIQUE

(30) Priority: 22.03.2024 CN 202410341764
(43) Date of publication of application: 15.10.2025
(73) Proprietor: AESC Japan Ltd., Yokohama-Shi, Kanagawa 220-0012 (JP)
(72) Inventor: HE, Yafei, Pudong New Area Shanghai, 201315 (CN); WANG, Yuxing, Pudong New Area Shanghai, 201315 (CN)
(74) Representative: Becker, Eberhard

(56) References cited:
- EP-A1- 3 968 441
- WO-A1-2020/192807
- GB-A- 2 586 058
- KR-B1- 101 619 449

## Description

### BACKGROUND

### Technical Field

The present disclosure relates to the field of battery technology, particularly to a shunt device, a cooling device, a battery pack and an electrical device.

### Description of Related Art

In the related technology, battery modules of power batteries are typically cooled by cooling devices to prevent excessive temperature rise of the battery modules, which might lead to the risk of thermal runaway. The cooling device typically includes cooling pipelines and cooling components connected to the cooling pipelines. The cooling pipelines are utilized for shunting the cooling medium, and the cooling components are utilized for heat exchange with the battery modules.

However, due to the need of frequent bending for setting the cooling pipelines, the flow resistance of the cooling pipelines is increased and a large space is occupied, which affects the heat exchange efficiency of the cooling device and reduces the energy density of the battery pack.

WO 2020/192807 A1 relates to a plastic heat exchanger with double manifold designed for thermal management of battery cells in battery packs of electric vehicles composed of hollow fiber rows and one double manifold with degas spout, which can be used for space and weight saving and also for increasing the number of battery cells. EP 3968441 A1 relates to a liquid filled heat exchanger for cylindrical battery cells for thermal regulation of battery modules for electric vehicles.

### SUMMARY

The invention is set out in the appended set of claims. The following disclosure serves a better understanding of the present invention. The present disclosure provides a shunt device, a cooling device, a battery pack and an electrical device, aiming to solve the problem of poor cooling effect of cooling devices in related technologies.

On one hand, the present disclosure provides a shunt device, the shunt device includes a shunt box body and a mounting structure set on the shunt box body, wherein the shunt box body internally has a first diversion cavity and a second diversion cavity that are not interconnected; the mounting structure includes a mounting channel for mounting the cooling component and a separating component set in the mounting channel, the mounting channel is disposed on the shunt box body and communicates with both the first diversion cavity and the second diversion cavity; the separating component separates the mounting channel into a first communicating channel and a second communicating channel that are independent of each other, and makes the first diversion cavity communicate with the cooling device only through the first communicating channel, while the second diversion cavity communicates with the cooling device only through the second communicating channel.

By applying the above technical solution, the shunt device may include a shunt box body and a mounting structure disposed within the shunt box body. The shunt box may shunt the cooling medium, which discards the conventional method of shunting through cooling pipelines. On one hand, the disclosure does not require setting up joint structures, thereby ensuring the flow rate and flow speed of the cooling medium, and saving space occupied by bent pipelines. On the other hand, the shunt box body internally integrates water inlet passages and water outlet passages, avoiding the need to set up water inlet passages and water outlet passages at both ends of the battery module, thus further saving occupied space and improving the energy density of the battery pack.

In some embodiments, the separating component includes: a dividing portion, disposed in the mounting channel and dividing the mounting channel into a first communicating channel and a second communicating channel; a first blocking portion, disposed in the first communicating channel to seal the second diversion cavity and the first communicating channel; a second blocking portion, disposed in the second communicating channel to seal the first diversion cavity and the second communicating channel. The first diversion cavity and the second diversion cavity both extend along a first direction, and the first diversion cavity and the second diversion cavity are disposed at intervals, wherein the first direction is the length direction of the shunt box body.

Such setting may ensure that the cooling water entering the cooling component will not be mixed.

In some embodiments, the first diversion cavity and the second diversion cavity may be spaced apart in the second direction. The mounting channel may be disposed on the side portion of the shunt box body. The projections of the mounting channel and the first diversion cavity are partially overlapped in the second direction, and the projections of the mounting channel and the second diversion cavity are partially overlapped in the second direction, wherein the second direction is perpendicular to the first direction.

Such setting may ensure that the lengths of the first diversion cavity and the second diversion cavity are uniform and independent of each other, thereby facilitating the setting of the mounting structure.

In some embodiments, the shunt box body includes a housing and a separating panel, wherein the housing has a diversion space inside, the separating panel divides the diversion space into a first diversion cavity and a second diversion cavity, and the mounting channel penetrates through the housing and connects the first diversion cavity and the second diversion cavity.

Such setting makes the structure of the shunt box body simple and convenient for processing.

In some embodiments, the separating panel has a first surface facing the first diversion cavity and a second surface facing the second diversion cavity.

The first communication channel includes a first wall close to the first surface and a second wall close to the second surface. The first wall and the second wall form the first communicating channel. The first blocking portion seals the gap between the second surface and the second wall to block the second diversion cavity from communicating with the first communicating channel.

The second communicating channel includes a third wall close to the first surface and a fourth wall close to the second surface. The third wall and the fourth wall form the second communicating channel; the second blocking portion seals the gap between the first surface and the third wall to block the first diversion cavity from communicating with the second communicating channel.

With such a setting, through the separating panel, the separation of the first diversion cavity and the second diversion cavity is achieved. The mounting channel penetrates the housing and extends to the separating panel, while the mounting channel may also communicate with both the first diversion cavity and the second diversion cavity. Since the mounting channel extends to the separating panel, the first blocking portion and the second blocking portion may utilize the position of the separating panel to achieve the sealing effect.

In some embodiments, the housing, separating panel and separating component may be integrally formed as a single structure.

In some embodiments, the shunt box body may also be provided with a liquid inlet connected to the first diversion cavity and a liquid outlet connected to the second diversion cavity.

Such setting may enable the shunt box to connect with the coolant circulation system, thereby achieving the circulation of the coolant.

On the other hand, the present disclosure provides a cooling device, including: a shunt device, which is the shunt device described above; a cooling component, having a cooling channel for cooling medium to flow through, wherein the first end of the cooling component is an open end, the second end of the cooling component is a closed end. The liquid inlet and liquid outlet of the cooling channel are both located at the first end of the cooling component, and the first end of the cooling component extends into the mounting channel of the shunt device, so that the liquid inlet is connected with the first communicating channel, and the liquid outlet is connected with the second communicating channel.

By applying the aforementioned cooling device, on one hand, it is possible to reduce the flow resistance of the coolant, and on the other hand, it is possible to decrease the occupied space, thereby increasing the energy density of the battery pack.

In some embodiments, the number of cooling components may be multiple, the multiple cooling components are spaced apart in a first direction, and the mounting structure includes multiple mounting structures in one-to-one correspondence with the cooling components, wherein the first direction is the length direction of the shunt box body.

Such setting may enhance the cooling efficiency and cooling uniformity of the cooling device.

In some embodiments, the first end of the cooling component is connected to the hole wall of the mounting channel in a sealed manner so as to reduce the risk of leakage of coolant.

In some embodiments, the first end of the cooling component is adhered to the hole wall of the mounting channel.

In the above-mentioned structure, the adhesive connection method may increase the connection stability between the cooling component and the mounting channel.

According to the claimed invention, the cooling component includes a housing and a separating panel, wherein the housing has a cooling channel therein, the separating panel is disposed in the cooling channel and divides the cooling channel into a liquid inlet cooling channel and a liquid outlet cooling channel. The liquid inlet cooling channel is connected with the first communicating channel, and the liquid outlet cooling channel is connected with the second communicating channel.

In the above-mentioned structure, the separating panel divides the cooling channel into a liquid inlet cooling channel and a liquid outlet cooling channel, making the liquid inlet passages and the water outlet passages not mix inside the cooling component, ensuring the circulation effect of the cooling medium.

In some embodiments, the first end of the housing is an open end, and the second end of the housing is a closed end. The separating panel extends from the open end of the housing towards the closed end of the housing, and there may be a gap between the separating panel and the end surface of the closed end. The liquid inlet cooling channel and the liquid outlet cooling channel may be connected through the gap.

The above-mentioned structure achieves the separation of the liquid inlet cooling channel and the liquid outlet cooling channel through setting the separating panel, ensuring the circulation effect of the cooling medium.

In some embodiments, the cooling component includes a cooling panel, the cooling panel has multiple placement grooves disposed along the flow direction of the cooling medium, and the placement grooves are configured for placing single cells.

In the above-mentioned structure, the processing method of the cooling panel is simple, and has a large contact area with the battery module, thereby effectively ensuring the cooling effect on the battery module. In addition, the cooling panel occupies a small space, which may further reduce the space occupied by the cooling device.

In some embodiments, placement grooves are disposed on two opposite panel surfaces of the cooling panel, and the placement grooves on the opposite sides of the cooling panel are staggered in the first direction, wherein the first direction is the length direction of the shunt box body.

Such setting may increase the contact area between the single cell and the cooling panel.

In some embodiments, the cooling panel may be wave-shaped in the first direction.

Such setting makes that in the situation where the single cells in the battery module are cylindrical single cells, the wave-shaped cooling panel has a large contact area with the side surface of the cylindrical single cells, resulting in better cooling effect.

On the other hand, the present disclosure provides a battery pack, including: a casing; a battery module disposed in the casing, the battery module including at least one single cell; a cooling device, disposed in the casing and in contact with the battery module, the cooling device being the cooling device described above.

Since the cooling device has the advantages of high cooling efficiency and occupation of small space, the battery pack with such a device has the advantages of higher safety and greater energy density of the battery pack.

In some embodiments, the width direction of the cooling component in the cooling device may be consistent with the length direction of the single cell.

Such setting may achieve contact between the cooling component and the side surface of the single cell, thereby ensuring the cooling effect.

In some embodiments, the battery module may include multiple sub-modules, each sub-module may include multiple single cells, and the cooling device may include multiple cooling components, with each sub-module in contact and cooperation with at least one cooling component.

Such setting may allow each sub-module to be cooled through the cooling component, thereby enhancing the cooling effect of the cooling device on the battery module.

In some embodiments, each sub-module includes multiple rows of single cells arranged along the height direction of the battery pack, with a cooling component disposed between two rows of adjacent single cells. The cooling component has a first heat exchange surface and a second heat exchange surface, both of which are in contact with the side surfaces of the single cells.

This setting method allows each row of single cells to be in contact with the cooling component, thereby further improving the cooling effect of the cooling device, ensuring the uniformity of cooling for the battery module.

On the other hand, the present disclosure provides an electrical device, including the battery pack described above. Since the battery pack has the advantages of higher energy density and better safety performance, the electrical device with such battery pack also has the advantages of good battery performance and high safety.

The shunt device provided by the present disclosure includes a shunt box, which includes a shunt box body and a mounting structure disposed on the shunt box body. The shunt box body has a first diversion cavity and a second diversion cavity that are not connected to each other, wherein the first diversion cavity may serve as the liquid inlet channel of the shunt box body, and the second diversion cavity may serve as the liquid outlet channel of the shunt box body. The first diversion cavity includes a first communicating channel, and the second diversion cavity includes a second communicating channel. The cooling component may be connected with the first communicating channel and the second communicating channel, thereby achieving the circulation of coolant in the cooling component.

Specifically, the shunt box body may be connected and communicated with the cooling component through a mounting structure. The mounting structure includes a mounting channel and a separating component. The mounting channel is disposed on the shunt box body and communicates with both the first diversion cavity and the second diversion cavity. The separating component is disposed inside the mounting channel. The separating component divides the mounting channel into a first communicating channel and a second communicating channel. Therefore, the cooling component may be inserted into the mounting channel. The first communicating channel and the second communicating channel may still form non-communicating channels within the mounting channel after being separated by the separating component. The cooling medium in the first diversion cavity may flow into the liquid inlet of the cooling component through the first communicating channel. After circulating in the cooling channel, the cooling medium is discharged from the liquid outlet to the second communicating channel, and then flows from the second communicating channel to the second diversion cavity, achieving the circulation of the cooling medium.

Since this embodiment adopts a shunt box as the shunt device for the cooling medium, the present disclosure abandons the conventional method of shunting through cooling pipelines, eliminating the need to set up joint structures, thereby ensuring the flow rate and flow speed of the cooling medium.

In addition, the shunt box internally integrates water inlet passages and water outlet passages, an mounting channel for mounting cooling components, and a separating component for shunting, thus avoiding the need to set up water inlet passages and water outlet passages at both ends of the battery module, thereby effectively saving space occupied by the shunt box body, allowing the battery module to have a larger mounting space, and consequently increasing the energy density of the battery pack.

### BRIEF DESCRIPTION OF THE DRAWINGS

The drawings incorporated herein and forming a part of the specification illustrate embodiments of the present disclosure and, together with the description, serve to explain the principles of the disclosure.
FIG. 1 is a perspective view of the cooling device provided by an embodiment of the present disclosure.
FIG. 2 is a top view of the cooling device provided by an embodiment of the present disclosure.
FIG. 3 is a sectional view of the cooling device of FIG. 2 taken along line A-A.
FIG. 4 is an enlarged structural view of portion C of the cooling device in FIG. 3.
FIG. 5 is a sectional view of the cooling device of FIG. 2 taken along line B-B.
FIG. 6 is an enlarged structural view of portion D of the cooling device in FIG. 5.
FIG. 7 is a top view of a partial structure of the cooling device provided by an embodiment of the present disclosure.
FIG. 8 is a cross-sectional view of the cooling device of FIG. 7 taken along line F-F.
FIG. 9 is a top view of a cooling component of the cooling device provided by an embodiment of the present disclosure.
FIG. 10 is a sectional view of the cooling component of FIG. 9 taken along line E-E.
FIG. 11 is a side view of a cooling panel of the cooling device provided by an embodiment of the present disclosure.
FIG. 12 is a perspective view of a shunt box of the cooling device provided by an embodiment of the present disclosure.
FIG. 13 is a perspective sectional view of a shunt box of the cooling device provided by an embodiment of the present disclosure.
FIG. 14 is a structural view of the battery pack provided by an embodiment of the present disclosure.
FIG. 15 is an exploded view of the battery module and the cooling device of the battery pack provided by an embodiment of the present disclosure.
FIG. 16 is a spatial rendering view of the shunt box of FIG. 13 from another perspective.
FIG. 17 is spatial rendering view of the shunt box of FIG. 13 from yet another perspective.

Through the above drawings, embodiments of the present disclosure have been shown clearly, and more detailed descriptions will be provided in the following text. These drawings and text descriptions are to explain the concept of the present disclosure to those skilled in the art by referring to specific embodiments.

### DESCRIPTION OF THE EMBODIMENTS

To make the purpose, technical solution and advantages of the present disclosure clearer, the technical solution in the embodiments of the present disclosure will be described clearly and completely in combination with the drawings in the embodiments of the present disclosure. Clearly, the described embodiments are only a part of the embodiments of the present disclosure, not all the embodiments. Based on the embodiments in the present disclosure, all other embodiments obtained by those skilled in the art without creative labor are within the protection scope of the appended set of claims.

In the related technology, power batteries generally include a battery pack, which includes a casing, a battery module disposed within the casing, and a cooling device for cooling the battery module. The function of the cooling device lies in reducing the temperature of the battery module to prevent excessive temperature rise of the battery module, thereby avoiding the risk of thermal runaway.

The cooling device in the related technology generally includes a cooling pipeline, which is used for circulating the cooling medium. The cooling medium may exchange heat with the battery module, thereby cooling the battery module. The cooling pipeline includes a main cooling pipe and branch cooling pipes. The main cooling pipe is connected to multiple branch cooling pipes, thereby shunting the cooling medium. The branch cooling pipes may be connected to cooling components such as cooling panels that contact the battery module, thereby cooling the battery module.

However, due to the numerous joints and bends in the cooling pipelines, the flow resistance of the cooling pipelines is high, which affects the flow speed of the cooling medium.

Secondly, since the main cooling pipe and the branch cooling pipes are generally set at an angle, the cooling device occupies a large space inside the battery pack, thereby compressing the mounting space of the battery module, resulting in a decrease in the energy density of the battery pack, which affects the performance of the battery.

In addition, the connection process of the cooling pipelines is complex, the processing efficiency is low, and the production cost is high, which is not conducive to cost control of the cooling device.

The present disclosure provides a shunt device, which includes a shunt box body and a mounting structure disposed inside the shunt box body. The shunt box may shunt the cooling medium, discarding the conventional method of shunting through cooling pipelines. On one hand, the present disclosure does not require setting up joint structures or bending the shunt panel, thus ensuring the flow rate and flow speed of the cooling medium and saving the space occupied by bent pipelines. On the other hand, the shunt box body internally integrates the water inlet passages and water outlet passages, avoiding the need to set up water inlet passages and water outlet passages at both ends of the battery module, thereby further saving occupied space and improving the energy density of the battery pack.

The following description, in conjunction with the accompanying drawings, explains the shunt device, cooling device, and battery pack provided by the embodiments of the present disclosure. It should be noted that the shunt device and cooling device provided by the embodiments of the present disclosure may be applied in a battery pack, where the single cells in the battery pack may be secondary batteries. That is, the batteries in the embodiments of the present disclosure may be charged and discharged and used cyclically. The specific types of batteries may include, but are not limited to, lithium batteries, etc. The scenarios where the batteries may be used include, but are not limited to, electronic products, energy storage devices, transportation vehicles, etc., such as mobile communication devices, new energy vehicles, drones, etc.

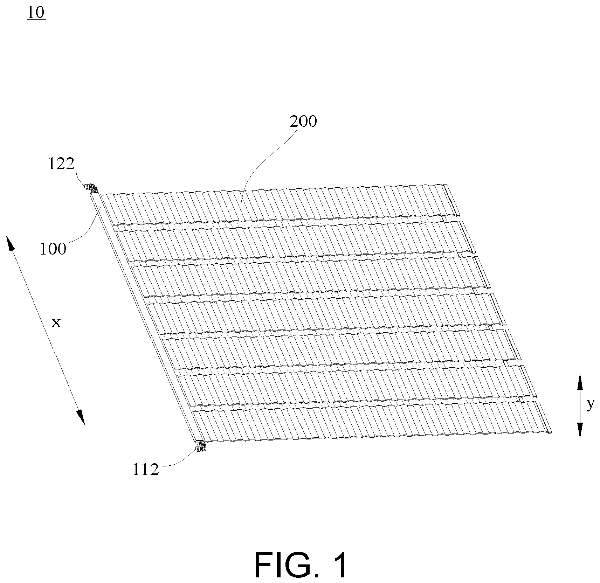

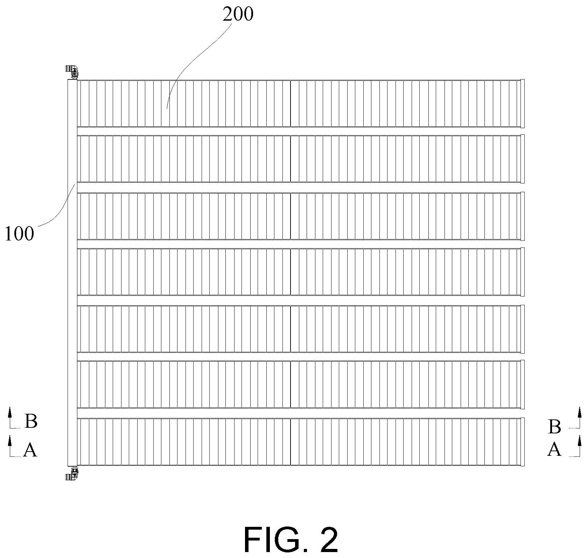

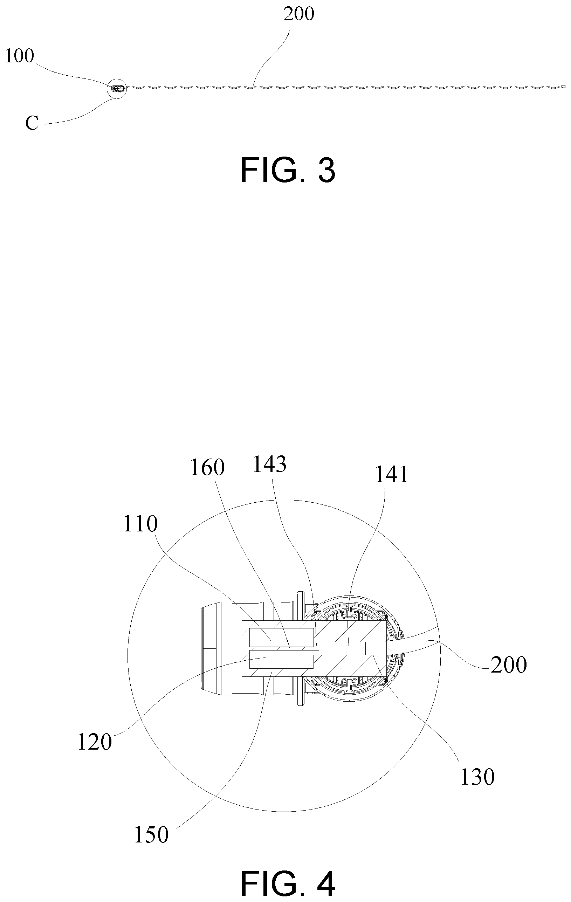

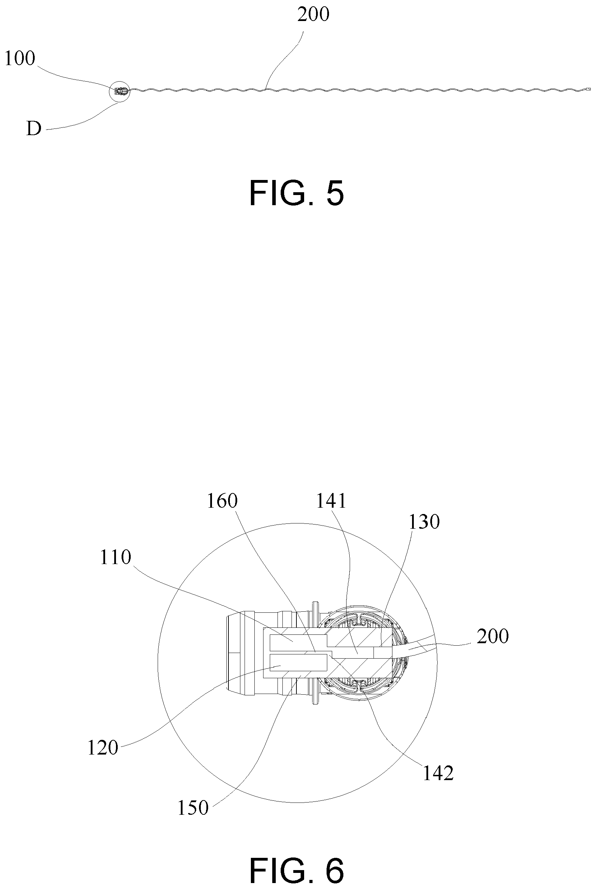

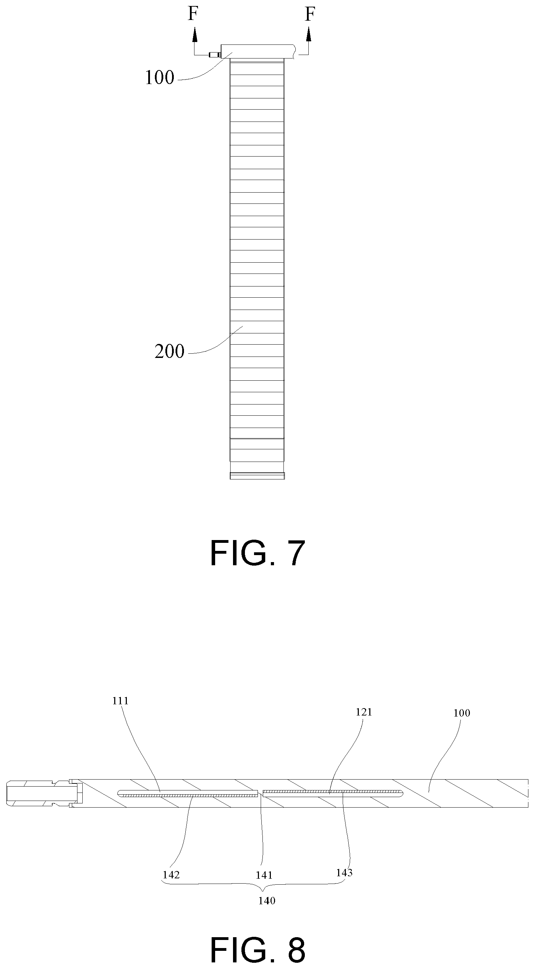

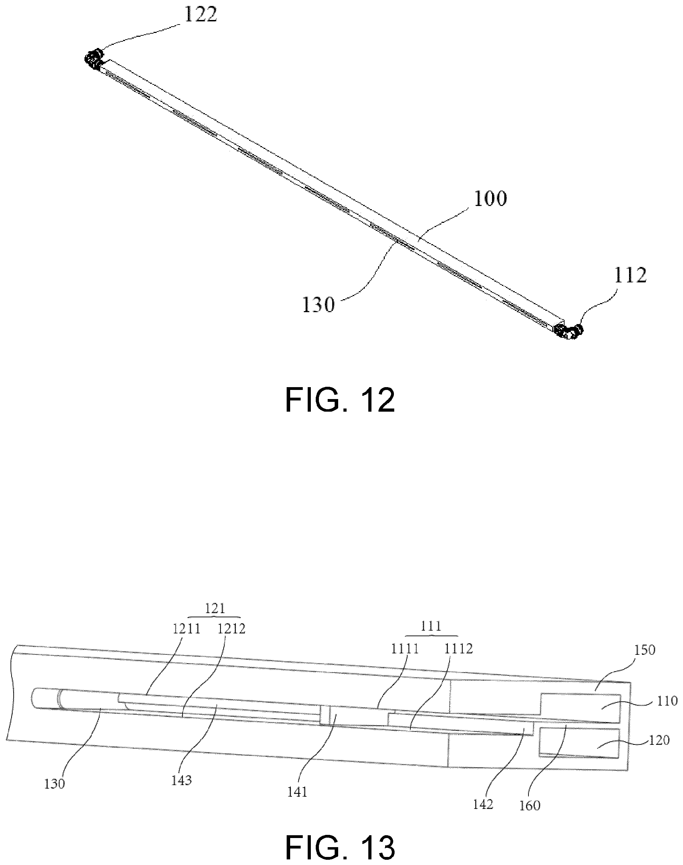

FIG. 1 is a perspective view of the cooling device provided by an embodiment of the present disclosure. FIG. 2 is a top view of the cooling device provided by an embodiment of the present disclosure. FIG. 3 is a sectional view of the cooling device of FIG. 2 taken along line A-A. FIG. 4 is an enlarged structural view of portion C of the cooling device in FIG. 3. FIG. 5 is a sectional view of the cooling device of FIG. 2 taken along line B-B. FIG. 6 is an enlarged structural view of portion D of the cooling device in FIG. 5. FIG. 7 is a top view of a partial structure of the cooling device provided by an embodiment of the present disclosure. FIG. 8 is a cross-sectional view of the cooling device of FIG. 7 taken along line F-F. FIG. 12 is a perspective view of a shunt box body of the cooling device provided by an embodiment of the present disclosure. FIG. 13 is a perspective sectional view of a shunt box of the cooling device provided by an embodiment of the present disclosure.

As shown in FIG.1 to FIG.6 as well as FIG.7, FIG.8, FIG.12 and FIG.13, the shunt device of this embodiment includes a shunt box body 100 and a mounting structure disposed within the shunt box body.

The shunt box body 100 internally has a first diversion cavity 110 and a second diversion cavity 120 that are not interconnected.

The mounting structure includes a mounting channel 130 for mounting the cooling component 200 and a separating component 140 set in the mounting channel 130, wherein the mounting channel 130 is disposed on the shunt box body 100 and communicates with both the first diversion cavity 110 and the second diversion cavity 120.

The separating component 140 separates the mounting channel 130 into a first communicating channel 111 and a second communicating channel 121 that are independent of each other, and makes the first diversion cavity 110 communicate with the cooling component 200 only through the first communicating channel 111, while the second diversion cavity 120 communicates with the cooling component 200 only through the second communicating channel 121.

By applying the technical solution of this embodiment, the shunt box body 100 internally has a first diversion cavity 110 and a second diversion cavity 120 that are not connected to each other. The first diversion cavity 110 may serve as the liquid inlet channel of the shunt box body 100, and the second diversion cavity 120 may serve as the liquid outlet channel of the shunt box body 100. The first diversion cavity 110 includes a first communicating channel 111, and the second diversion cavity 120 includes a second communicating channel 121. The cooling component 200 may be connected with the first communicating channel 111 and the second communicating channel 121, thereby achieving the circulation of coolant in the cooling component 200.

Specifically, the shunt box body 100 may be connected and communicated with the cooling component 200 through a mounting structure, which includes a mounting channel 130 and a separating component 140. The mounting channel 130 is disposed on the shunt box body 100 and communicates with both the first diversion cavity 110 and the second diversion cavity 120. The mounting channel 130 is utilized for connecting the cooling component 200. The separating component 140 is disposed inside the mounting channel 130, dividing the mounting channel 130 into a first communicating channel 111 and a second communicating channel 121. Therefore, the cooling component 200 may be inserted into the mounting channel 130. After being separated by the separating component 140, the first communicating channel 111 and the second communicating channel 121 may still form non-communicating channels within the mounting channel 130. The cooling medium in the first diversion cavity 110 may flow into the liquid inlet end of the cooling component 200 through the first communicating channel 111. After circulating in the cooling channel, the cooling medium is discharged from the liquid outlet end to the second communicating channel 121, and then flows from the second communicating channel 121 to the second diversion cavity 120, achieving the circulation of the cooling medium.

Since this embodiment adopts a shunt box as the shunt device for the cooling medium, discarding the conventional method of shunting through cooling pipelines, there is no need to set up joint structures, thereby ensuring the flow rate and flow speed of the cooling medium.

In addition, the shunt box internally integrates water inlet passages, water outlet passages, a mounting channel 130 for mounting cooling components, and a separating component 140 for shunting, thus avoiding setting up water inlet passages and water outlet passages at both ends of the battery module, thereby effectively saving space occupied by the shunt box body, allowing the battery module to have a large mounting space, and thus increasing the energy density of the battery pack.

As shown in FIG. 4, FIG. 6 to FIG. 8, FIG. 12 and FIG. 13, in some embodiments, the separating component 140 includes: a dividing portion 141, a first blocking portion 142, and a second blocking portion 143.

The dividing portion 141 is disposed in the mounting channel 130 and divides the mounting channel 130 into a first communicating channel 111 and a second communicating channel 121, allowing two mutually independent channels to be formed in the mounting channel 130. The first blocking portion 142 is disposed in the first communicating channel 111 to seal the second diversion cavity 120 and the first communicating channel 111, thereby making the first communicating channel 111 only communicate with the first diversion cavity 110. The second blocking portion 143 is disposed in the second communicating channel 121 to seal the first diversion cavity 110 and the second communicating channel 121, thereby making the second communicating channel 121 only communicate with the second diversion cavity 120.

By adopting the above-mentioned separating component 140, the mounting channel 130 may be formed with mutually independent first communicating channel 111 and second communicating channel 121 through the dividing portion 141. Through the first blocking portion 142, it is possible to seal the second diversion cavity 120 and the first communicating channel 111, and at the same time, communication between the first communicating channel 111 and the first diversion cavity 110 is realized, allowing liquid to flow into the cooling component 200 without mixing the water inlet passage with the water outlet passage. Through the second blocking portion 143, it is possible to seal the first diversion cavity 110 and the second communicating channel 121, and at the same time, communication between the second communicating channel 121 and the second diversion cavity 120 is realized, allowing liquid to flow into the cooling component 200 without mixing the water outlet passage with the water inlet passage, ensuring the cooling effect of the cooling device.

As shown in FIG. 1, FIG. 4, FIG. 6, FIG. 8, FIG. 12 and FIG. 13, in some embodiments, both the first diversion cavity 110 and the second diversion cavity 120 extend along a first direction (such as the x direction shown in FIG. 1), and the first diversion cavity 110 and the second diversion cavity 120 are disposed at intervals, wherein the first direction is the length direction of the shunt box body 100. Such arrangement may ensure that the first diversion cavity 110 and the second diversion cavity 120 have uniform length and are independent of each other, thereby facilitating the setting of the mounting structure.

As shown in FIG. 1, FIG. 4, FIG. 6, FIG. 8 to FIG. 12, in some embodiments, the first diversion cavity 110 and the second diversion cavity 120 are disposed at intervals in the second direction (such as the y direction shown in FIG. 1), the mounting channel 130 is disposed at the side portion of the shunt box body 100, the projections of the mounting channel 130 and the first diversion cavity 110 are partially overlapped in the second direction, and the projections of the mounting channel 130 and the second diversion cavity 120 are partially overlapped in the second direction, wherein the second direction is perpendicular to the first direction.

Such arrangement makes the layout of the first diversion cavity 110, the second diversion cavity 120 and the mounting channel 130 on the shunt box body 100 reasonable. The mounting channel 130 forms a three-way structure that may connect the first diversion cavity 110, the second diversion cavity 120 and the cooling channel. The separating component 140 prevents the water inlet passage in the first diversion cavity 110 from mixing with the water outlet passage in the second diversion cavity 120.

It should be further noted that, by setting up the mounting channel 130 and the separating component 140 inside the shunt box body 100, the water inlet passage and water outlet passage may achieve shunting within the shunt box body 100, without the need for additional shunt structures. This ensures the miniaturized design of the cooling device, effectively saving space occupied by the cooling device.

As shown in FIG.4, FIG.6 to FIG.8, FIG.12 and FIG.13, in some embodiments, the shunt box body 100 includes a housing 150 and a separating panel 160. The housing 150 has a diversion space inside, the separating panel 160 divides the diversion space into a first diversion cavity 110 and a second diversion cavity 120, and the mounting channel 130 penetrates through the housing 150 and connects the first diversion cavity 110 and the second diversion cavity 120. This setup makes the structure of the shunt box body 100 simple and convenient to process.

Specifically, the shunt box body 100 may be processed and formed through an extrusion method. The material of the shunt box body 100 may be aluminum or aluminum alloy, such as Al3003 or A16061. The above-mentioned materials have high thermal conductivity and light weight, which helps to improve the thermal conductivity efficiency of the cooling device 10 and reduce the self-weight of the cooling device 10.

As shown in FIG. 4, FIG. 6 to FIG. 8, FIG. 12 and FIG. 13, in some embodiments, the separating panel 160 has a first surface facing the first diversion cavity 110 and a second surface facing the second diversion cavity 120. The first communicating channel 111 includes a first wall 1111 near the first surface and a second wall 1112 near the second surface. The first wall 1111 and the second wall 1112 form the first communicating channel 111. The first blocking portion 142 seals the gap between the second surface and the second wall 1112 to block the second diversion cavity 120 from communicating with the first communicating channel 111.

Correspondingly, in some embodiments, the second communicating channel 121 includes a third wall 1211 near the first surface and a fourth wall 1212 near the second surface, the third wall 1211 and the fourth wall 1212 form the second communicating channel 121; the second blocking portion 143 seals the gap between the first surface and the third wall 1211, to block the first diversion cavity 110 from communicating with the second communicating channel 121.

With such a configuration, through the separating panel 160, the separation of the first diversion cavity 110 and the second diversion cavity 120 is achieved. The mounting channel 130 penetrates through the housing 150 and extends to the separating panel 160, while the mounting channel 130 may also communicate with both the first diversion cavity 110 and the second diversion cavity 120. Since the mounting channel 130 extends to the separating panel 160, the first blocking portion 142 and the second blocking portion 143 may utilize the position where the separating panel 160 is located to achieve a sealing effect.

Specifically, the first communicating channel 111 includes a first wall 1111 close to the first surface and a second wall 1112 close to the second surface. The first wall 1111 and the second wall 1112 may form the first communicating channel 111. The second blocking portion 143 may seal the gap between the first surface and the third wall 1211, thereby blocking the second diversion cavity 120 and the first communicating channel 111, making the first diversion cavity 110 only able to communicate with the first communicating channel 111.

Correspondingly, the second communicating channel 121 includes a third wall 1211 close to the first surface and a fourth wall 1212 close to the second surface. The third wall 1211 and the fourth wall 1212 may form the second communicating channel 121. The second blocking portion 143 seals the gap between the first surface and the third wall 1211, thereby blocking the first diversion cavity 110 and the second communicating channel 121, making the second diversion cavity 120 only able to communicate with the second communicating channel 121.

It should be further noted that, in some embodiments, the housing 150, the separating panel 160, and the separating component 140 may be an integrally formed structure, and may be processed and formed by means of profile extrusion.

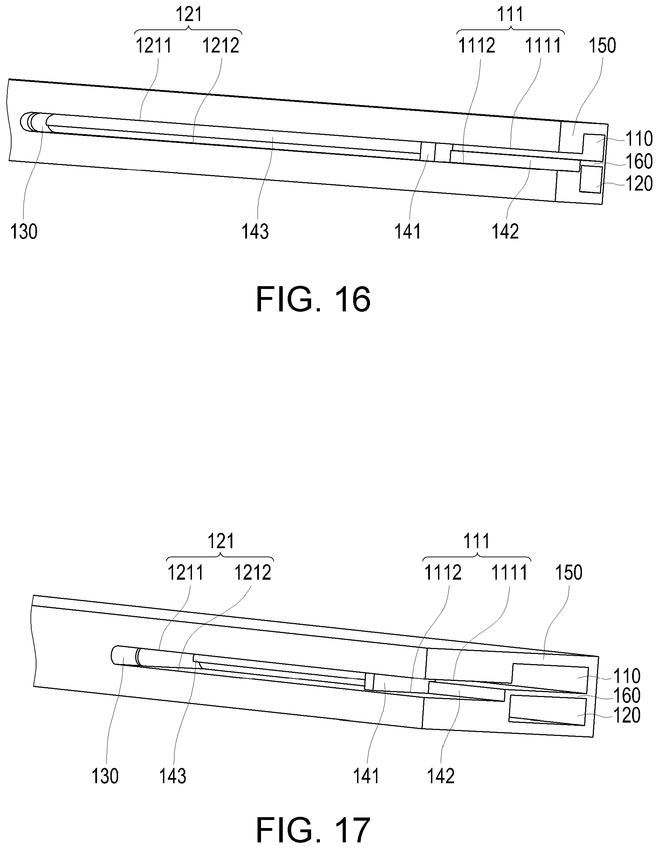

In addition, FIG. 16 is a spatial rendering view of the shunt box of FIG. 13 from another perspective. FIG. 17 is spatial rendering view of the shunt box of FIG. 13 from yet another perspective. That is, FIG. 16 and FIG. 17 show other perspectives of FIG. 13. FIG. 16 and FIG. 17 more intuitively show the structure and set position of the dividing portion 141, the first blocking portion 142, and the second blocking portion 143 in the separating component 140.

As shown in FIG. 12, in some embodiments, the shunt box body 100 is further provided with a liquid inlet 112 communicating with the first diversion cavity 110 and a liquid outlet 122 communicating with the second diversion cavity 120. The liquid inlet 112 and the liquid outlet 122 may be utilized to connect to a circulation device for the cooling medium, thereby achieving the circulating flow of the cooling medium.

On the other hand, the present disclosure also provides a cooling device, the embodiment of the cooling device includes: a shunt device and a cooling component 200.

The shunt device is the aforementioned shunt device. The cooling component 200 has a cooling channel for the cooling medium to flow through. The first end of the cooling component 200 is an open end, and the second end of the cooling component 200 is a closed end. The liquid inlet 112 and liquid outlet of the cooling channel are both located at the first end of the cooling component 200. The first end of the cooling component 200 extends into the mounting channel 130 of the shunt device, so that the liquid inlet 112 is connected with the first communicating channel 111, and the liquid outlet is connected with the second communicating channel 121.

In the above-mentioned structure, the first end of the cooling component 200 is inserted into the mounting channel 130, but since the water inlet passages and water outlet passages need to be set independently to avoid mixing of the two and resulting in reduced cooling effect, it is required to use the separating component 140 to divide the mounting channel 130. Specifically, the separating component 140 is disposed in the mounting channel 130 and divides the mounting channel 130 into non-communicating first communicating channel 111 and second communicating channel 121. The cooling medium in the first diversion cavity 110 may flow into the cooling channel through the first communicating channel 111 and the liquid inlet end. After circulating in the cooling channel, the cooling medium flows into the second diversion cavity 120 through the liquid outlet end and the second communicating channel 121, achieving the circulation of the cooling medium. Therefore, by setting the separating component 140 in the mounting channel 130 to form non-communicating first communicating channel 111 and second communicating channel 121, the overall structure of the shunt box body 100 is made simpler and more compact, which helps to save the space occupied by the shunt box body 100.

In other embodiments not shown in the drawings, the cooling component may also include multiple cooling pipelines or cooling coils or other cooling assemblies arranged in parallel.

As shown in FIG. 1 and FIG. 2, in some embodiments, the number of cooling components 200 is multiple, and the multiple cooling components 200 are disposed at intervals in the first direction. The mounting structure includes multiple mounting structures in one-to-one correspondence with the cooling components 200, wherein the first direction is the length direction of the shunt box body 100.

In the above-mentioned structure, the number of cooling components 200 is multiple, and each cooling component 200 may contact the battery module 400, thereby enhancing the cooling effect on the battery module 400. Meanwhile, multiple cooling components 200 may also increase the cooling uniformity of the cooling device 10 on the battery module 400, thus reducing the probability of localized temperature rise in the battery module 400, and consequently lowering the risk of thermal runaway in single cells.

The specific structure of the cooling component will be described below in conjunction with the accompanying drawings.

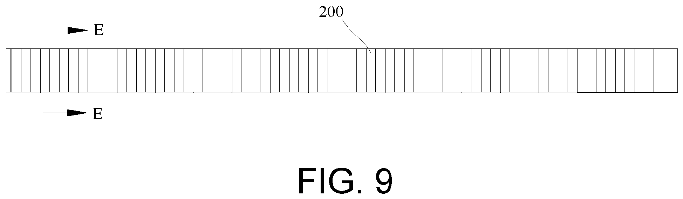

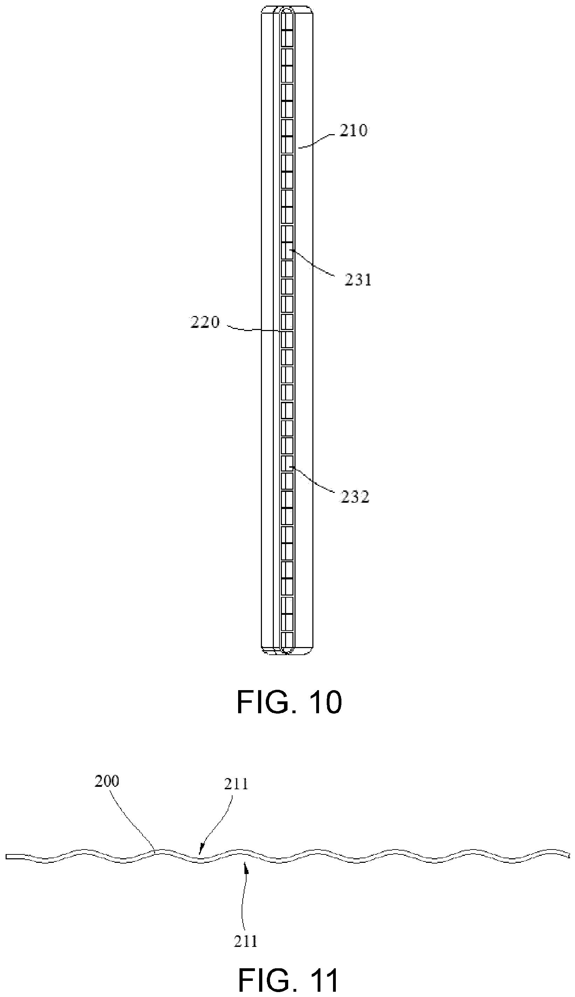

FIG. 9 is a top view of a cooling component of the cooling device provided by an embodiment of the present disclosure. FIG. 10 is a sectional view of the cooling component of FIG. 9 taken along line E-E. FIG. 11 is a side view of a cooling panel of the cooling device provided by an embodiment of the present disclosure.

As shown in FIG. 1, FIG. 2 and FIG. 9 to FIG. 11, the first end of the cooling component 200 extends into the mounting channel 130 and is connected with the hole wall of the mounting channel 130 in a sealed manner, so as to reduce the risk of leakage of the cooling medium.

Specifically, as shown in FIG. 1 and FIG. 2, in some embodiments, the first end of the cooling component 200 is adhered to the hole wall of the mounting channel 130.

In the above-mentioned structure, the adhesive connection method may, on one hand, increase the connection stability between the cooling component 200 and the mounting channel 130, and on the other hand, achieve sealing between the first end of the cooling component 200 and the hole wall of the mounting channel 130, thereby reducing the risk of leakage of the cooling medium.

Specifically, when the cooling component 200 is mounted, the first end of the cooling component 200 may be first inserted into the mounting channel 130, and then the gap between the first end of the cooling component 200 and the hole wall of the mounting channel 130 may be sealed by applying adhesive. Compared with welding, such connection method has the advantages of simple process and high processing efficiency.

Of course, in some embodiments, the first end of the cooling component may also be inserted into the mounting channel through an interference fit, thereby ensuring the sealing between the cooling component 200 and the mounting channel.

Alternatively, in some embodiments, sealing may also be achieved by setting a sealing ring between the cooling component and the hole wall of the mounting channel.

As shown in FIG. 9 and FIG. 10, in some embodiments, the cooling component 200 includes a housing 210 and a separating panel 220. The housing 210 has a cooling channel inside, and the separating panel 220 is disposed in the cooling channel and divides the cooling channel into a liquid inlet cooling channel 231 and a liquid outlet cooling channel 232. The liquid inlet cooling channel 231 is connected with the first communicating channel 111, and the liquid outlet cooling channel 232 is connected with the second communicating channel 121.

In the above-mentioned structure, the separating panel 220 may divide the cooling channel into a liquid inlet cooling channel 231 and a liquid outlet cooling channel 232, making the water inlet passages and the water outlet passages not mix inside the cooling component 200, ensuring the circulation effect of the cooling medium.

Specifically, the flow path of the cooling medium is as follows: the cooling medium first enters the first diversion cavity 110, passes through the first communicating channel 111 to flow into the liquid inlet cooling channel 231, then flows from the liquid inlet cooling channel 231 into the liquid outlet cooling channel 232, converges to the second diversion cavity 120 via the second communicating channel 121, and finally discharges from the shunt box body.

As shown in FIG. 10, in some embodiments, the first end of the housing 210 is an open end, and the second end of the housing 210 is a closed end. The separating panel 220 may extend from the open end of the housing 210 towards the closed end of the housing 210, and there may be a gap between the separating panel 220 and the end surface of the closed end. The liquid inlet cooling channel 231 and the liquid outlet cooling channel 232 may be connected through the gap.

In the above-mentioned structure, through setting the separating panel 220, the separation of the liquid inlet cooling channel 231 and the liquid outlet cooling channel 232 is achieved. The liquid inlet cooling channel 231 and the liquid outlet cooling channel 232 form a "U-shaped" channel, ensuring the circulation effect of the cooling medium.

It should be noted that the number of separating panels 220 may be multiple, and multiple separating panels 220 are disposed at intervals in the width direction of the housing 210, so as to form multiple "U-shaped" channels in the cooling channel, making the cooling medium enter the cooling channel and flow in an orderly manner with consistent flow direction, avoiding turbulence of the cooling medium in the cooling cavity, and improving the smoothness of the cooling medium circulation.

As shown in FIG. 1, FIG. 2 and FIG. 11, in some embodiments, the cooling component 200 includes a cooling panel. The cooling panel has a simple processing method and a large contact area with the battery module, thereby effectively ensuring the cooling effect on the battery module. In addition, the cooling panel occupies a small space, which may further reduce the space occupied by the cooling device.

As shown in FIG. 11, the cooling panel has multiple placement grooves 211 set along the flow direction of the cooling medium, and the placement grooves 211 are utilized for placing single cells. The placement grooves 211 may increase the contact area between the single cells and the cooling panel. Specifically, the groove walls of the placement grooves 211 may be configured to match the contour of the side walls of the single cells in order to increase the contact area between the placement grooves 211 and the single cells.

As shown in FIG. 11, in some embodiments, placement grooves 211 may be disposed on two opposite panel surfaces of the cooling panel, and the placement grooves 211 located on the opposite sides of the cooling panel are staggered in the first direction. This setting method makes both sides of the cooling panel form heat exchange surfaces in contact with the single cells, ensuring the cooling effect of the cooling panel.

As shown in FIG. 11, in some embodiments, the cooling panel may be wave-shaped in the first direction. In the situation where the single cells in the battery module are cylindrical single cells, the wave-shaped cooling panel may have a larger contact area with the side surface of the cylindrical single cells, resulting in better cooling effect.

It may be noted that the cooling component may be processed and formed by extrusion of profiles. The material of the cooling component may be aluminum or aluminum alloy, such as Al3003 or Al6061. The above materials have high thermal conductivity and light weight, which helps to improve the thermal conductivity efficiency of the cooling device and reduce the self-weight of the cooling device.

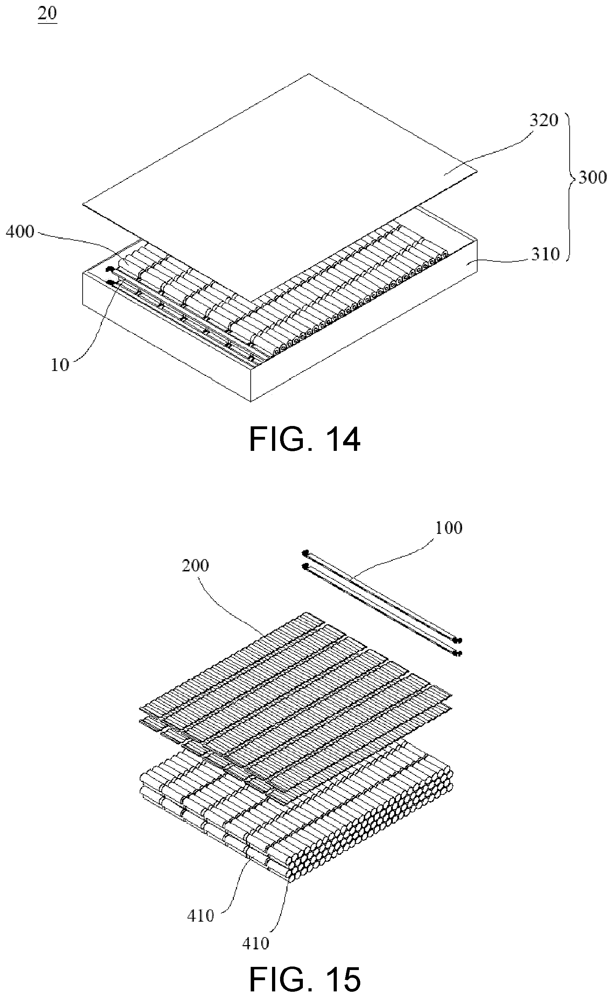

On the other hand, the present disclosure provides a battery pack. FIG. 14 is a structural view of the battery pack provided by an embodiment of the present disclosure; FIG. 15 is an exploded view of the battery module and cooling device of the battery pack provided by an embodiment of the present disclosure.

As shown in FIG. 14 and FIG. 15, the battery pack 20 of this embodiment includes: a casing 300, a battery module 400, and a cooling device 10.

The casing 300 includes a box bottom 310 and a lid 320 covering the box bottom 310, the box bottom 310 and the lid 320 may form an accommodating space for placing the battery module 400 and the cooling device 10. The battery module 400 includes at least one single cell, the battery module 400 and the cooling device 10 are both disposed in the accommodating space of the casing 300, and the cooling device 10 may contact and cooperate with the battery module 400, thereby cooling the battery module 400.

As an example, the battery module 400 may be a conventional battery module (including single cells and a restraining structure external to the single cells), or may be a battery module directly composed of single cells.

Due to the advantage of occupying less space, the cooling device enables the battery pack to have a larger space for setting up battery modules, thereby increasing the energy density and improving the performance of the battery pack. Moreover, the cooling device also has the advantages of high cooling efficiency and good cooling uniformity, therefore the battery pack equipped with the cooling device has a lower risk of thermal runaway and better safety.

As shown in FIG. 14 and FIG. 15, in some embodiments, the width direction of the cooling component 200 in the cooling device 10 is consistent with the length direction of the single cell. With such a setting, the cooling component may achieve contact with the side surface of the single cell, thereby ensuring the cooling effect.

It should be noted that the "side surface of the single cell" mentioned above refers to surfaces of the single cell other than the surface where the electrodes are located. For example, in the case where the single cell is a cylindrical battery, the "side surface of the single cell" refers to the cylindrical side surface of the cylindrical battery excluding the surface where the positive electrode is located and the surface where the negative electrode is located. In the case where the single cell is a prismatic battery, the "side surface of the single cell" refers to other side surfaces of the prismatic battery excluding the plane where the positive electrode and the negative electrode are located.

Exemplarily, in the embodiments shown in FIG. 14 and FIG. 15, the single cell is a cylindrical single cell, and the cylindrical single cell is disposed in the battery pack in a side-mounted method. To ensure the cooling effect of the cooling component 200, the heat exchange surface of the cooling component 200 should be in contact with the side surface of the cylindrical single cell, thereby ensuring the cooling effect.

As shown in FIG.14 and FIG.15, in some embodiments, the battery module 400 includes multiple sub-modules 410. Each sub-module 410 includes multiple single cells, and the cooling device 10 includes multiple cooling components 200. Each sub-module 410 is in contact and cooperation with at least one cooling component 200, thereby enabling each sub-module 410 to be cooled through the cooling component 200, thus enhancing the cooling effect of the cooling device 10 on the battery module 400. At the same time, multiple cooling components 200 may also increase the cooling uniformity of the cooling device 10 on the battery module 400, thereby reducing the probability of localized temperature rise in the battery module 400, so as to reduce the risk of thermal runaway of single cells.

As shown in FIG. 14 and FIG. 15, in some embodiments, each sub-module 410 includes multiple rows of single cells arranged along the height direction of the battery pack 20, that is, the single cells are disposed in a side-mounted manner in the battery pack 20, and a cooling component 200 is disposed between two rows of adjacent single cells. The cooling component 200 has a first heat exchange surface and a second heat exchange surface, both of which are in contact with the side surfaces of the single cells. This arrangement method ensures that each row of single cells may contact the cooling component, thereby further enhancing the cooling effect of the cooling device and ensuring the cooling uniformity of battery module.

On the other hand, the present disclosure provides an electrical device (not shown in the drawings) including the battery pack 20 described above. Since the battery pack has advantages of higher energy density and better safety performance, the electrical device with the battery pack also has advantages of good battery performance and high safety.

In the description of the present disclosure, it should be noted that, unless otherwise explicitly specified and limited, the terms "mount", "connect", and "link" should be understood in a broad sense. For example, it may be a fixed connection, or it may be indirectly connected through an intermediate medium. It may be an internal communication between two elements or an interaction between two elements. For those skilled in the art, the specific meaning of the above terms in the present disclosure can be understood according to specific situations.

In the description of the present disclosure, it should be understood that terms such as "upper", "lower", "front", "rear", "vertical", "horizontal", "top", "bottom", "inner", "outer" and other indications of orientation or positional relationships are based on the orientation or positional relationships shown in the drawings, and are only for the purpose of facilitating the description of the present disclosure and simplifying the description, rather than indicating or implying that the device or element referred to must have a specific orientation, be constructed or operated in a specific orientation. Therefore, they should not be understood as limitations on the present disclosure.

The terms "first", "second", "third", "fourth", etc. (if present) in the specification, claims, and the above-mentioned drawings of the present disclosure are used to distinguish similar objects, and are not necessarily used to describe a specific order or sequence. It should be understood that such data may be interchangeable under appropriate circumstances, so that the embodiments of the present disclosure described herein may, for example, be implemented in an order other than that illustrated or described herein.

Furthermore, the terms "include" and "have" and any variations thereof are intended to cover non-exclusive inclusion. For example, a process, method, system, product, or device that includes a series of steps or units may not be limited to those steps or units that are clearly listed, but may include other steps or units that are not clearly listed or are inherent to these processes, methods, products, or devices.

Finally, it should be noted that: the above embodiments are only used to illustrate the technical solution of the present disclosure, and not to limit it; although the disclosure has been described in detail with reference to the foregoing embodiments, those skilled in the art should understand that: they may still modify the technical solution described in the foregoing embodiments, or make equivalent substitutions for part or all of the technical features; and these modifications or substitutions do not make the corresponding technical solution deviate from the scope of the appended set of claims.

### [LIST OF REFERENCE NUMERALS]

10 Cooling device
20 Battery pack
100 Shunt box body
110 First diversion cavity
111 First communicating channel
1111 First wall
1112 Second wall
112 Liquid inlet
120 Second diversion cavity
121 Second communicating channel
1211 Third wall
1212 Fourth wall
122 Liquid outlet
130 Mounting channel
140 Separating component
141 Dividing portion
142 First blocking portion
143 Second blocking portion
150 Housing
160 Separating panel
200 Cooling component
210 Housing
211 Placement groove
220 Separating panel
231 Liquid inlet cooling channel
232 Liquid outlet cooling channel
300 Casing
310 Box bottom
320 Lid
400 Battery module
410 Sub-module

## Claims

1. A cooling device (10), comprising:
a shunt device, comprising a shunt box body (100) and a mounting structure disposed on the shunt box body (100), wherein,
the shunt box body (100) internally comprises a first diversion cavity (110) and a second diversion cavity (120) that are not interconnected;
the mounting structure comprises a mounting channel (130) for mounting a cooling component (200) and a separating component (140) disposed in the mounting channel (130), the mounting channel (130) is disposed on the shunt box body (100) and communicates with both the first diversion cavity (110) and the second diversion cavity (120);
the separating component (140) divides the mounting channel (130) into a first communicating channel (111) and a second communicating channel (121) that are independent of each other, and makes the first diversion cavity (110) communicate with the cooling component (200) only through the first communicating channel (111), and makes the second diversion cavity (120) communicate with the cooling component (200) only through the second communicating channel (121),
wherein the cooling component (200) comprises a cooling channel for a cooling medium to circulate, a first end of the cooling component (200) is an open end, a second end of the cooling component (200) is a closed end, a second liquid inlet and a second liquid outlet of the cooling channel are both located at the first end of the cooling component (200), the first end of the cooling component (200) extends into the mounting channel (130) of the shunt device to make the second liquid inlet connected with the first communicating channel (111), and the second liquid outlet connected with the second communicating channel (121),
the cooling device (10) is **characterized in that**
the cooling component (200) comprises the second housing (210) and the second separating panel (220), the second housing (210) has the cooling channel therein, the second separating panel (220) is disposed in the cooling channel and divides the cooling channel into a liquid inlet cooling channel (231) and a liquid outlet cooling channel (232), the liquid inlet cooling channel (231) is connected with the first communicating channel (111), and the liquid outlet cooling channel (232) is connected with the second communicating channel (121).

2. The cooling device (10) according to claim 1, wherein the separating component (140) comprises:
a dividing portion (141), disposed in the mounting channel (130) and dividing the mounting channel (130) into the first communicating channel (111) and the second communicating channel (121);
a first blocking portion (142), disposed in the first communicating channel (111) to block the second diversion cavity (120) from communicating with the first communicating channel (111);
a second blocking portion (143), disposed in the second communicating channel (121) to block the first diversion cavity (110) from communicating with the second communicating channel (121).

3. The cooling device (10) according to claim 1, wherein the first diversion cavity (110) and the second diversion cavity (120) both extend along a first direction, and the first diversion cavity (110) and the second diversion cavity (120) are disposed at intervals, wherein the first direction is a length direction of the shunt box body (100).

4. The cooling device (10) according to claim 3, wherein the first diversion cavity (110) and the second diversion cavity (120) are disposed at intervals in a second direction, the mounting channel (130) is disposed at a side portion of the shunt box body (100), projections of the mounting channel (130) and the first diversion cavity (110) are partially overlapped in the second direction, and projections of the mounting channel (130) and the second diversion cavity (120) are partially overlapped in the second direction, wherein the second direction is perpendicular to the first direction.

5. The cooling device (10) according to claim 2, wherein the shunt box body (100) comprises a first housing (150) and a first separating panel (160), the first housing (150) has a diversion space inside, the first separating panel (160) divides the diversion space into the first diversion cavity (110) and the second diversion cavity (120), and the mounting channel (130) penetrates through the first housing (150) and connects the first diversion cavity (110) and the second diversion cavity (120).

6. The cooling device (10) according to claim 5, wherein the first separating panel (160) has a first surface facing the first diversion cavity (110) and a second surface facing the second diversion cavity (120);
the first communicating channel (111) comprises a first wall (1111) close to the first surface and a second wall (1112) close to the second surface, the first wall (1111) and the second wall (1112) form the first communicating channel (111); the first blocking portion (142) seals a gap between the second surface and the second wall (1112) to block the second diversion cavity (120) from communicating with the first communicating channel (111);
the second communicating channel (121) comprises a third wall (1211) close to the first surface and a fourth wall (1212) close to the second surface, the third wall (1211) and the fourth wall (1212) form the second communicating channel (121); the second blocking portion (143) seals a gap between the first surface and the third wall (1211) to block the first diversion cavity (110) from communicating with the second communicating channel (121).

7. The cooling device (10) according to claim 5, wherein the first housing (150), the first separating panel (160) and the separating component (140) are an integrally formed structure.

8. The cooling device (10) according to any one of claims 1 to 7, wherein the shunt box body (100) further comprises a first liquid inlet (112) connected to the first diversion cavity (110) and a first liquid outlet (122) connected to the second diversion cavity (120).

9. The cooling device (10) according to claim 1, wherein the number of the cooling components (200) is multiple, a plurality of cooling components (200) are spaced apart in the first direction, the mounting structure comprises a plurality of mounting structures in one-to-one correspondence with the cooling components (200), wherein the first direction is the length direction of the shunt box body (100).

10. The cooling device (10) according to claim 1, wherein the first end of the cooling component (200) is connected with a hole wall of the mounting channel (130) in a sealed manner.

11. The cooling device (10) according to claim 10, wherein the first end of the cooling component (200) is adhered to the hole wall of the mounting channel (130).

12. The cooling device (10) according to claim 1, wherein a first end of the second housing (210) is an open end, a second end of the second housing (210) is a closed end, the second separating panel (220) extends from the open end of the second housing (210) towards the closed end of the second housing (210), and there is a gap between the second separating panel (220) and an end surface of the closed end, the liquid inlet cooling channel (231) and the liquid outlet cooling channel (232) are connected through the gap.

13. The cooling device (10) according to claim 1, wherein the cooling component (200) comprises a cooling panel, the cooling panel has a plurality of placement grooves (211) disposed in a flow direction of the cooling medium, the plurality of placement grooves (211) are for placing single cells.

14. The cooling device (10) according to claim 13, wherein the placement grooves (211) are disposed on two opposite panel surfaces of the cooling panel, and the placement grooves (211) on opposite sides of the cooling panel are staggered in the first direction, wherein the first direction is the length direction of the shunt box body (100).

15. The cooling device (10) according to claim 14, wherein the cooling panel is wave-shaped in the first direction.

16. A battery pack (20), comprising:
a casing (300);
a battery module (400), disposed in the casing (300), the battery module (400) comprising at least one single cell;
a cooling device (10), disposed in the casing (300) and in contact with the battery module (400), the cooling device (10) being the cooling device according to any one of claims 1 to 15.

17. The battery pack (20) according to claim 16, wherein a width direction of the cooling component (200) in the cooling device (10) is consistent with a length direction of the single cell.

18. The battery pack (20) according to claim 16, wherein the battery module (400) comprises a plurality of sub-modules (410), each of the sub-modules (410) comprising a plurality of the single cells, the cooling device (10) comprises a plurality of the cooling components (200), each of the sub-modules (410) is in contact and cooperation with at least one of the cooling components (200).

19. The battery pack (20) according to claim 18, wherein each of the sub-modules (410) comprises a plurality of rows of the single cells arranged along a height direction of the battery pack (20), with one of the cooling components (200) disposed between the two rows of adjacent single cells, the cooling component (200) has a first heat exchange surface and a second heat exchange surface, both of the first heat exchange surface and the second heat exchange surface are in contact with side surfaces of the single cells.

20. An electrical device, comprising the battery pack (20) according to any one of claims 16 to 19.

## Patentansprüche

1. Kühlvorrichtung (10), umfassend:
eine Abzweigvorrichtung, umfassend einen Abzweigkastenkörper (100) und eine an dem Abzweigkastenkörper (100) angeordnete Befestigungsstruktur, wobei
der Abzweigkastenkörper (100) im Inneren einen ersten Umleitungshohlraum (110) und einen zweiten Umleitungshohlraum (120) umfasst, die nicht miteinander verbunden sind;
die Befestigungsstruktur einen Befestigungskanal (130) zur Befestigung einer Kühlkomponente (200) und eine in dem Befestigungskanal (130) angeordnete Trennkomponente (140) umfasst, wobei der Befestigungskanal (130) an dem Abzweigkastenkörper (100) angeordnet ist und sowohl mit dem ersten Umleitungshohlraum (110) als auch mit dem zweiten Umleitungshohlraum (120) in Verbindung steht;
die Trennkomponente (140) den Befestigungskanal (130) in einen ersten Verbindungskanal (111) und einen zweiten Verbindungskanal (121), die voneinander unabhängig sind, unterteilt, und den ersten Umleitungshohlraum (110) nur über den ersten Verbindungskanal (111) mit der Kühlkomponente (200) in Verbindung bringt und den zweiten Umleitungshohlraum (120) nur über den zweiten Verbindungskanal (121) mit der Kühlkomponente (200) in Verbindung bringt,
wobei die Kühlkomponente (200) einen Kühlkanal für die Zirkulation eines Kühlmediums umfasst, ein erstes Ende der Kühlkomponente (200) ein offenes Ende ist, ein zweites Ende der Kühlkomponente (200) ein geschlossenes Ende ist, sich sowohl ein zweiter Flüssigkeitseinlass als auch ein zweiter Flüssigkeitsauslass des Kühlkanals an dem ersten Ende der Kühlkomponente (200) befinden, sich das erste Ende der Kühlkomponente (200) in den Befestigungskanal (130) der Abzweigvorrichtung erstreckt, um den zweiten Flüssigkeitseinlass mit dem ersten Verbindungskanal (111) und den zweiten Flüssigkeitsauslass mit dem zweiten Verbindungskanal (121) zu verbinden,
die Kühlvorrichtung (10) **dadurch gekennzeichnet ist, dass**
die Kühlkomponente (200) das zweite Gehäuse (210) und die zweite Trennplatte (220) umfasst, das zweite Gehäuse (210) den Kühlkanal in sich aufweist, die zweite Trennplatte (220) in dem Kühlkanal angeordnet ist und den Kühlkanal in einen Flüssigkeitseinlass-Kühlkanal (231) und einen Flüssigkeitsauslass-Kühlkanal (232) unterteilt, der Flüssigkeitseinlass-Kühlkanal (231) mit dem ersten Verbindungskanal (111) verbunden ist und der Flüssigkeitsauslass-Kühlkanal (232) mit dem zweiten Verbindungskanal (121) verbunden ist.

2. Kühlvorrichtung (10) nach Anspruch 1, wobei die Trennkomponente (140) umfasst:
einen Trennabschnitt (141), der in dem Befestigungskanal (130) angeordnet ist und den Befestigungskanal (130) in den ersten Verbindungskanal (111) und den zweiten Verbindungskanal (121) unterteilt;
einen ersten Sperrabschnitt (142), der in dem ersten Verbindungskanal (111) angeordnet ist, um zu verhindern, dass der zweite Umleitungshohlraum (120) mit dem ersten Verbindungskanal (111) in Verbindung steht;
einen zweiten Sperrabschnitt (143), der in dem zweiten Verbindungskanal (121) angeordnet ist, um zu verhindern, dass der erste Umleitungshohlraum (110) mit dem zweiten Verbindungskanal (121) in Verbindung steht.

3. Kühlvorrichtung (10) nach Anspruch 1, wobei sich sowohl der erste Umleitungshohlraum (110) als auch der zweite Umleitungshohlraum (120) entlang einer ersten Richtung erstrecken und der erste Umleitungshohlraum (110) und der zweite Umleitungshohlraum (120) in Abständen angeordnet sind, wobei die erste Richtung eine Längsrichtung des Abzweigkastenkörpers (100) ist.

4. Kühlvorrichtung (10) nach Anspruch 3, wobei der erste Umleitungshohlraum (110) und der zweite Umleitungshohlraum (120) in einer zweiten Richtung in Abständen angeordnet sind, der Befestigungskanal (130) an einem Seitenabschnitt des Abzweigkastenkörpers (100) angeordnet ist, sich Projektionen des Befestigungskanals (130) und des ersten Umleitungshohlraums (110) in der zweiten Richtung teilweise überlappen und sich Projektionen des Befestigungskanals (130) und des zweiten Umleitungshohlraums (120) in der zweiten Richtung teilweise überlappen, wobei die zweite Richtung senkrecht zu der ersten Richtung verläuft.

5. Kühlvorrichtung (10) nach Anspruch 2, wobei der Abzweigkastenkörper (100) ein erstes Gehäuse (150) und eine erste Trennplatte (160) umfasst, das erste Gehäuse (150) im Inneren einen Umleitungsraum aufweist, die erste Trennplatte (160) den Umleitungsraum in den ersten Umleitungshohlraum (110) und den zweiten Umleitungshohlraum (120) unterteilt und der Befestigungskanal (130) das erste Gehäuse (150) durchdringt und den ersten Umleitungshohlraum (110) mit dem zweiten Umleitungshohlraum (120) verbindet.

6. Kühlvorrichtung (10) nach Anspruch 5, wobei die erste Trennplatte (160) eine dem ersten Umleitungshohlraum (110) zugewandte erste Oberfläche und eine dem zweiten Umleitungshohlraum (120) zugewandte zweite Oberfläche aufweist;
der erste Verbindungskanal (111) eine erste Wand (1111) nahe der ersten Oberfläche und eine zweite Wand (1112) nahe der zweiten Oberfläche umfasst, wobei die erste Wand (1111) und die zweite Wand (1112) den ersten Verbindungskanal (111) bilden; der erste Sperrabschnitt (142) einen Spalt zwischen der zweiten Oberfläche und der zweiten Wand (1112) abdichtet, um zu verhindern, dass der zweite Umleitungshohlraum (120) mit dem ersten Verbindungskanal (111) in Verbindung steht;
der zweite Verbindungskanal (121) eine dritte Wand (1211) nahe der ersten Oberfläche und eine vierte Wand (1212) nahe der zweiten Oberfläche umfasst, wobei die dritte Wand (1211) und die vierte Wand (1212) den zweiten Verbindungskanal (121) bilden; der zweite Sperrabschnitt (143) einen Spalt zwischen der ersten Oberfläche und der dritten Wand (1211) abdichtet, um zu verhindern, dass der erste Umleitungshohlraum (110) mit dem zweiten Verbindungskanal (121) in Verbindung steht.

7. Kühlvorrichtung (10) nach Anspruch 5, wobei das erste Gehäuse (150), die erste Trennplatte (160) und die Trennkomponente (140) eine einstückig geformte Struktur bilden.

8. Kühlvorrichtung (10) nach einem der Ansprüche 1 bis 7, wobei der Abzweigkastenkörper (100) ferner einen ersten Flüssigkeitseinlass (112), der mit dem ersten Umleitungshohlraum (110) verbunden ist, und einen ersten Flüssigkeitsauslass (122) umfasst, der mit dem zweiten Umleitungshohlraum (120) verbunden ist.

9. Kühlvorrichtung (10) nach Anspruch 1, wobei die Anzahl der Kühlkomponenten (200) mehr als eins beträgt, eine Vielzahl von Kühlkomponenten (200) in der ersten Richtung beabstandet sind und die Befestigungsstruktur eine Vielzahl von Befestigungsstrukturen umfasst, die in einer Eins-zu-Eins-Entsprechung zu den Kühlkomponenten (200) stehen, wobei die erste Richtung die Längsrichtung des Abzweigkastenkörpers (100) ist.

10. Kühlvorrichtung (10) nach Anspruch 1, wobei das erste Ende der Kühlkomponente (200) in abgedichteter Weise mit einer Lochwand des Befestigungskanals (130) verbunden ist.

11. Kühlvorrichtung (10) nach Anspruch 10, wobei das erste Ende der Kühlkomponente (200) an der Lochwand des Befestigungskanals (130) angehaftet ist.

12. Kühlvorrichtung (10) nach Anspruch 1, wobei ein erstes Ende des zweiten Gehäuses (210) ein offenes Ende ist, ein zweites Ende des zweiten Gehäuses (210) ein geschlossenes Ende ist, sich die zweite Trennplatte (220) von dem offenen Ende des zweiten Gehäuses (210) in Richtung des geschlossenen Endes des zweiten Gehäuses (210) erstreckt, und zwischen der zweiten Trennplatte (220) und einer Endfläche des geschlossenen Endes ein Spalt vorhanden ist, wobei der Flüssigkeitseinlass-Kühlkanal (231) und der Flüssigkeitsauslass-Kühlkanal (232) durch den Spalt verbunden sind.

13. Kühlvorrichtung (10) nach Anspruch 1, wobei die Kühlkomponente (200) eine Kühlplatte umfasst, die Kühlplatte eine Vielzahl von in einer Strömungsrichtung des Kühlmediums angeordneten Aufnahmenuten (211) aufweist, wobei die Vielzahl von Aufnahmenuten (211) zum Aufnehmen von Einzelzellen dient.

14. Kühlvorrichtung (10) nach Anspruch 13, wobei die Aufnahmenuten (211) an zwei gegenüberliegenden Plattenoberflächen der Kühlplatte angeordnet sind und die Aufnahmenuten (211) auf gegenüberliegenden Seiten der Kühlplatte in der ersten Richtung versetzt angeordnet sind, wobei die erste Richtung die Längsrichtung des Abzweigkastenkörpers (100) ist.

15. Kühlvorrichtung (10) nach Anspruch 14, wobei die Kühlplatte in der ersten Richtung wellenförmig gebildet ist.

16. Batteriepack (20), umfassend:
ein Gehäuse (300);
ein Batteriemodul (400), das in dem Gehäuse (300) angeordnet ist, wobei das Batteriemodul (400) mindestens eine Einzelzelle umfasst;
eine in dem Gehäuse (300) angeordnete und mit dem Batteriemodul (400) in Kontakt stehende Kühlvorrichtung (10), wobei die Kühlvorrichtung (10) die Kühlvorrichtung nach einem der Ansprüche 1 bis 15 ist.

17. Batteriepack (20) nach Anspruch 16, wobei eine Breitenrichtung der Kühlkomponente (200) in der Kühlvorrichtung (10) mit einer Längenrichtung der Einzelzelle übereinstimmt.

18. Batteriepack (20) nach Anspruch 16, wobei das Batteriemodul (400) eine Vielzahl von Untermodulen (410) umfasst, wobei jedes der Untermodule (410) eine Vielzahl von Einzelzellen umfasst, die Kühlvorrichtung (10) eine Vielzahl von Kühlkomponenten (200) umfasst, jedes der Untermodule (410) mit mindestens einer der Kühlkomponenten (200) in Kontakt steht und zusammenwirkt.

19. Batteriepack (20) nach Anspruch 18, wobei jedes der Untermodule (410) eine Vielzahl von Reihen der Einzelzellen umfasst, die entlang einer Höhenrichtung des Batteriepacks (20) angeordnet sind, wobei eine der Kühlkomponenten (200) zwischen den zwei Reihen angrenzender Einzelzellen angeordnet ist, die Kühlkomponente (200) eine erste Wärmeaustauschfläche und eine zweite Wärmeaustauschfläche aufweist, wobei sowohl die erste Wärmeaustauschfläche als auch die zweite Wärmeaustauschfläche mit Seitenflächen der Einzelzellen in Kontakt stehen.

20. Elektrische Vorrichtung, umfassend den Batteriepack (20) nach einem der Ansprüche 16 bis 19.

## Revendications

1. Dispositif de refroidissement (10), comprenant :
un dispositif de dérivation, comprenant un corps de boîtier de dérivation (100) et
une structure de montage disposée sur le corps de boîtier de dérivation (100), dans lequel : le corps de boîtier de dérivation (100) comprend, en son intérieur, une première cavité de dérivation (110) et une deuxième cavité de dérivation (120) qui ne sont pas reliées entre elles;
la structure de montage comprend un canal de montage (130) destiné à monter un élément de refroidissement (200) et un élément de séparation (140) disposé dans le canal de montage (130), le canal de montage (130) étant disposé sur le corps de boîtier de dérivation (100) et communiquant à la fois avec la première cavité de dérivation (110) et avec la deuxième cavité de dérivation (120) ;
le élément de séparation (140) divise le canal de montage (130) en un premier canal de communication (111) et un deuxième canal de communication (121) qui sont indépendants l'un de l'autre, et fait en sorte que la première cavité de dérivation (110) communique avec le élément de refroidissement (200) uniquement par l'intermédiaire du premier canal de communication (111), et fait en sorte que la deuxième cavité de dérivation (120) communique avec le élément de refroidissement (200) uniquement par l'intermédiaire du deuxième canal de communication (121),
dans lequel le élément de refroidissement (200) comprend un canal de refroidissement destiné à la circulation d'un fluide de refroidissement, une première extrémité du élément de refroidissement (200) est une extrémité ouverte, une deuxième extrémité du élément de refroidissement (200) est une extrémité fermée, une deuxième entrée de liquide et une deuxième sortie de liquide du canal de refroidissement sont toutes deux situées à la première extrémité du élément de refroidissement (200), la première extrémité du élément de refroidissement (200) s'étend dans le canal de montage (130) du dispositif de dérivation afin de relier la deuxième entrée de liquide au premier canal de communication (111), et la deuxième sortie de liquide au deuxième canal de communication (121),
le dispositif de refroidissement (10) est **caractérisé en ce que**
le élément de refroidissement (200) comprend le deuxième boîtier (210) et la deuxième cloison de séparation (220), le deuxième boîtier (210) comporte le canal de refroidissement à l'intérieur, la deuxième cloison de séparation (220) est disposée dans le canal de refroidissement et divise celui-ci en un canal de refroidissement d'entrée de liquide (231) et un canal de refroidissement de sortie de liquide (232), le canal de refroidissement d'entrée de liquide (231) étant relié au premier canal de communication (111), et le canal de refroidissement de sortie de liquide (232) étant relié au deuxième canal de communication (121).

2. Dispositif de refroidissement (10) selon la revendication 1, dans lequel l'élément de séparation (140) comprend :
une partie de séparation (141), disposée dans le canal de montage (130) et divisant le canal de montage (130) en un premier canal de communication (111) et un deuxième canal de communication (121) ;
une première partie d'obturation (142), disposée dans le premier canal de communication (111) pour empêcher la deuxième cavité de dérivation (120) de communiquer avec le premier canal de communication (111) ;
une deuxième partie d'obturation (143), disposée dans le deuxième canal de communication (121) pour empêcher la première cavité de dérivation (110) de communiquer avec le deuxième canal de communication (121).

3. Dispositif de refroidissement (10) selon la revendication 1, dans lequel la première cavité de dérivation (110) et la deuxième cavité de dérivation (120) s'étendent toutes deux selon une première direction, et la première cavité de dérivation (110) et la deuxième cavité de dérivation (120) sont disposées à intervalles réguliers, la première direction étant une direction longitudinale du corps de boîtier de dérivation (100).

4. Dispositif de refroidissement (10) selon la revendication 3, dans lequel la première cavité de dérivation (110) et la deuxième cavité de dérivation (120) sont disposées à intervalles réguliers dans une deuxième direction, le canal de montage (130) est disposé au niveau d'une partie latérale du corps de boîtier de dérivation (100), les saillies du canal de montage (130) et de la première cavité de dérivation (110) se chevauchent partiellement dans la deuxième direction, et les saillies du canal de montage (130) et de la deuxième cavité de dérivation (120) se chevauchent partiellement dans la deuxième direction, la deuxième direction étant perpendiculaire à la première direction.

5. Dispositif de refroidissement (10) selon la revendication 2, dans lequel le corps de boîtier de dérivation (100) comprend un premier boîtier (150) et une première cloison de séparation (160), le premier boîtier (150) comporte un espace de dérivation à l'intérieur, la première cloison de séparation (160) divise l'espace de dérivation en une première cavité de dérivation (110) et une deuxième cavité de dérivation (120), et le canal de montage (130) traverse le premier boîtier (150) et relie la première cavité de dérivation (110) à la deuxième cavité de dérivation (120).

6. Dispositif de refroidissement (10) selon la revendication 5, dans lequel la première cloison de séparation (160) comporte une première surface tournée vers la première cavité de dérivation (110) et une deuxième surface tournée vers la deuxième cavité de dérivation (120);
le premier canal de communication (111) comprend une première paroi (1111) proche de la première surface et une deuxième paroi (1112) proche de la deuxième surface, la première paroi (1111) et la deuxième paroi (1112) formant le premier canal de communication (111) ; la première partie d'obturation (142) obturent un interstice entre la deuxième surface et la deuxième paroi (1112) afin d'empêcher la deuxième cavité de dérivation (120) de communiquer avec le premier canal de communication (111) ;
le deuxième canal de communication (121) comprend une troisième paroi (1211) proche de la première surface et une quatrième paroi (1212) proche de la deuxième surface ; la troisième paroi (1211) et la quatrième paroi (1212) forment le deuxième canal de communication (121) ; la deuxième partie d'obturation (143) colmate un interstice entre la première surface et la troisième paroi (1211) afin d'empêcher la première cavité de dérivation (110) de communiquer avec le deuxième canal de communication (121).

7. Dispositif de refroidissement (10) selon la revendication 5, dans lequel le premier boîtier (150), le premier cloison de séparation (160) et l'élément de séparation (140) constituent une structure formée d'un seul tenant.

8. Dispositif de refroidissement (10) selon l'une quelconque des revendications 1 à 7, dans lequel le corps de boîtier de dérivation (100) comprend en outre une première entrée de liquide (112) reliée à la première cavité de dérivation (110) et une première sortie de liquide (122) reliée à la deuxième cavité de dérivation (120).

9. Dispositif de refroidissement (10) selon la revendication 1, dans lequel le nombre d'éléments de refroidissement (200) est multiple, une pluralité d'éléments de refroidissement (200) sont espacés les uns des autres dans la première direction, la structure de montage comprend une pluralité de structures de montage en correspondance biunivoque avec les éléments de refroidissement (200), la première direction étant la direction longitudinale du corps de boîtier de dérivation (100).

10. Dispositif de refroidissement (10) selon la revendication 1, dans lequel la première extrémité de l'élément de refroidissement (200) est reliée de manière étanche à une paroi percée du canal de montage (130).

11. Dispositif de refroidissement (10) selon la revendication 10, dans lequel la première extrémité du élément de refroidissement (200) est collée à la paroi percée du canal de montage (130).

12. Dispositif de refroidissement (10) selon la revendication 1, dans lequel une première extrémité du deuxième boîtier (210) est une extrémité ouverte, une deuxième extrémité du deuxième boîtier (210) est une extrémité fermée, le deuxième cloison de séparation (220) s'étend depuis l'extrémité ouverte du deuxième boîtier (210) vers l'extrémité fermée du deuxième boîtier (210), et il existe un interstice entre le deuxième cloison de séparation (220) et une surface d'extrémité de l'extrémité fermée, le canal de refroidissement d'entrée de liquide (231) et le canal de refroidissement de sortie de liquide (232) étant reliés par cet interstice.

13. Dispositif de refroidissement (10) selon la revendication 1, dans lequel le élément de refroidissement (200) comprend un cloison de refroidissement, le cloison de refroidissement comporte une pluralité de rainures de positionnement (211) disposées dans le sens d'écoulement du fluide de refroidissement, la pluralité de rainures de positionnement (211) étant destinées à recevoir des cellules individuelles.

14. Dispositif de refroidissement (10) selon la revendication 13, dans lequel les rainures de positionnement (211) sont disposées sur deux faces opposées du cloison de refroidissement, et les rainures de positionnement (211) situées sur les côtés opposés du cloison de refroidissement sont décalées dans la première direction, la première direction étant la direction longitudinale du corps du boîtier de dérivation (100).

15. Dispositif de refroidissement (10) selon la revendication 14, dans lequel le cloison de refroidissement présente une forme ondulée dans la première direction.

16. Bloc-batterie (20), comprenant :
un boîtier (300) ;
un module de batterie (400), disposé dans le boîtier (300), le module de batterie (400) comprenant au moins une cellule individuelle ;
un dispositif de refroidissement (10), disposé dans le boîtier (300) et en contact avec le module de batterie (400), le dispositif de refroidissement (10) étant le dispositif de refroidissement selon l'une quelconque des revendications 1 à 15.

17. Bloc-batterie (20) selon la revendication 16, dans lequel la direction de la largeur du élément de refroidissement (200) dans le dispositif de refroidissement (10) coïncide avec la direction de la longueur de la cellule unique.

18. Bloc-batterie (20) selon la revendication 16, dans lequel le module de batterie (400) comprend une pluralité de sous-modules (410), chacun des sous-modules (410) comprenant une pluralité de cellules individuelles, le dispositif de refroidissement (10) comprend une pluralité de éléments de refroidissement (200), chacun des sous-modules (410) étant en contact et en coopération avec au moins l'un des éléments de refroidissement (200).

19. Bloc-batterie (20) selon la revendication 18, dans lequel chacun des sous-modules (410) comprend une pluralité de rangées de cellules individuelles disposées le long d'une direction de hauteur du bloc-batterie (20), l'un des éléments de refroidissement (200) étant disposé entre deux rangées de cellules individuelles adjacentes, le élément de refroidissement (200) présentant une première surface d'échange thermique et une deuxième surface d'échange thermique, la première surface d'échange thermique et la deuxième surface d'échange thermique étant toutes deux en contact avec les surfaces latérales des cellules individuelles.

20. Dispositif électrique, comprenant le bloc-batterie (20) selon l'une quelconque des revendications 16 à 19.
